# EUROPÄISCHE PATENTSCHRIFT

(11) **EP 3 488 451 B1**
(45) Veröffentlichungstag und Bekanntmachung des Hinweises auf die Patenterteilung: **04.12.2019**
(21) Anmeldenummer: 17757758.2
(22) Anmeldetag: 24.08.2017
(51) Int. Cl.: H01F 6/04, G01R 33/3815

(54) **VORRICHTUNG UND VERFAHREN ZUM UNTERKÜHLTEN BETRIEB EINES KRYOSTATEN MIT GERINGEN MENGEN KÜHLMITTEL**
APPARATUS AND METHOD FOR SUPER-COOLED OPERATION OF A CRYOSTAT WITH LOW QUANTITIES OF COOLANT
DISPOSITIF ET PROCÉDÉ PERMETTANT UN FONCTIONNEMENT SURREFROIDI D'UN CRYOSTAT AVEC DE FAIBLES QUANTITÉS DE RÉFRIGÉRANT

(30) Priorität: 20.09.2016 DE 102016218000
(43) Veröffentlichungstag der Anmeldung: 29.05.2019
(73) Patentinhaber: Bruker BioSpin GmbH, 76287 Rheinstetten (DE)
(72) Erfinder: STROBEL, Marco, 76137 Karlsruhe (DE); WIKUS, Patrick, 8309 Nürensdorf (CH)
(74) Vertreter: Kohler Schmid Möbus Patentanwälte
(86) Internationale Anmeldenummer: PCT/EP2017/071340
(87) Internationale Veröffentlichungsnummer: WO 2018/054648

(56) Entgegenhaltungen:
- EP-A2- 1 736 723
- DE-B3-102014 219 849
- US-A1- 2009 193 816

## Beschreibung

Die Erfindung betrifft eine Kryostatenanordnung mit einem Vakuumbehälter und einem zu kühlenden Objekt, insbesondere einem supraleitenden Magnetspulensystem oder einem Kryobehälter, wobei das zu kühlende Objekt innerhalb des Vakuumbehälters angeordnet ist, wobei der Vakuumbehälter ein Halsrohr aufweist, das zum zu kühlenden Objekt führt, wobei ein Kühlarm eines Kaltkopfs zumindest teilweise im Halsrohr angeordnet ist, wobei um den Kühlarm herum ein abgeschlossener Hohlraum ausgebildet ist, der gegenüber dem zu kühlenden Objekt fluiddicht abgedichtet ist, wobei der Hohlraum im Normalbetrieb zumindest teilweise mit einem kryogenen Fluid gefüllt ist, und wobei ein thermisches Kopplungsmittel vorgesehen ist, geeignet zur thermischen Kopplung des kryogenen Fluids im Hohlraum mit dem zu kühlenden Objekt.

Eine solche Kryostatenanordnung ist aus der DE 10 2014 218 773 A1 (=Referenz [1]) bekannt geworden.

### Hintergrund der Erfindung

Kernspinresonanz(=NMR)-Apparaturen, insbesondere NMR-Spektrometer und NMR-Tomographen, benötigen starke Magnetfelder, die oftmals mittels supraleitender Magnetspulen erzeugt werden. Die supraleitenden Magnetspulen müssen auf einer kryogenen Temperatur betrieben werden. Die Magnetspulen sind dafür typischerweise in einem Kryostaten angeordnet. Der Kryostat weist einen evakuierten Behälter ("Vakuumbehälter") auf, in welchem ein zu kühlendes Objekt angeordnet ist, oft noch umgeben von einem Strahlungsschild. Das zu kühlende Objekt kann die Magnetspule selbst sein ("cryofree"- System), oder auch ein Kryobehälter, in welchem eine kryogene Flüssigkeit (etwa flüssiges Helium) und die Magnetspule angeordnet sind.

In der Kryotechnik werden zum Kühlen von Objekten -beispielsweise supraleitender Magnetspulen- meistens Kühlmaschinen verwendet, welche mittels eines Kühlkopfes die Wärme aus der Apparatur mit dem zu kühlenden Objekt abführen. Das zu kühlende Objekt wird in der Regel mit einem aktiven Kühlsystem, meist umfassend einen Pulsrohrkühler oder einen Gifford-MacMahon Kühler, gekühlt. Aktive Kühlsysteme reduzieren den Verbrauch an teurem flüssigem Helium, erhöhen die Verfügbarkeit der NMR-Apparatur und können auch zur Reduktion der Bauhöhe beitragen. Das aktive Kühlsystem kann einstufig oder auch mehrstufig ausgebildet sein. Bei mehrstufigen Systemen kühlt meist eine wärmere Kaltstufe den thermischen Strahlungsschild und eine kältere Kaltstufe das zu kühlende Objekt. Die bekannten Kühlmaschinen arbeiten typischerweise mit Heliumgas als Kühlmittel, welches in einem Kompressor komprimiert und im Kühlkopf des Kryostaten entspannt wird, wie etwa beim Pulsrohr-Kühler. Kühlkopf und Kompressor sind in der Regel durch zwei Druckleitungen miteinander verbunden. Der Kühlkopf ist mit den zu kühlenden Bauteilen entweder direkt mechanisch oder durch ein Kontaktmedium (z.B. Kryo-Gas oder Kryo-Flüssigkeit) oder durch beides verbunden, um einen guten Wärmeübergang zu gewährleisten.

Fällt jedoch der Kompressor -etwa durch einen technischen Defekt oder Stromausfall- ganz oder teilweise aus, erwärmen sich die vormals gekühlten Bauteile. Der Kühlkopf des Kryostaten stellt in dieser Situation dann eine erhebliche Wärmebrücke zwischen den zu kühlenden Bauteilen und der Außenwelt dar. Bei einem supraleitenden Magneten kann in seinem persistiven Betriebsmodus der supraleitende Strom über extrem lange Zeiträume praktisch widerstandsfrei fließen. Eine Erwärmung des Magneten hingegen führt nach einer gewissen Zeit zum sogenannten "Quench" des persistiven Betriebsmodus: Der Magnet erreicht irgendwann die durch das Supraleitermaterial vorgegebene kritische Sprung-Temperatur, wird normalleitend und verliert dabei -in der Regel schlagartig- sein hohes Magnetfeld.

Wenn sich ein solcher Ausfall des aktiven Kühlsystems ereignet, sollte das supraleitendes Magnetspulensystem zumindest so lange unterhalb der Sprungtemperatur verbleiben können, bis eine Reparatur des aktiven Kühlsystems vorgenommen werden kann oder der Strom/Wasserausfall überwunden ist. Ein Verlust des supraleitenden Zustands macht ein erneutes Abkühlen des supraleitenden Magnetspulensystems nötig, was mit beträchtlichem Aufwand verbunden ist.

Bei den häufigsten Bauformen von Kryostaten mit aktiver Kühlung, wie etwa in der US 2007/089432 A beschrieben, ragt der Kühlarm eines Kühlkopfes in ein Halsrohr eines Vakuumbehälters. Das Halsrohr ist zu einem Kryobehälter hin offen, in welchem eine supraleitende Magnetspule in flüssigem Helium angeordnet ist. An der untersten Kühlstufe des Kühlarms rekondensiert Helium und tropft in den Kryobehälter zurück. Ähnliche Kryostaten sind aus der US 2010/298148 A, der US 2007/022761A, der DE 10 2004 012 416 B4 oder der US 2007/051115 A bekannt geworden.

Um die verfügbare Zeit zwischen einem Ausfall eines aktiven Kühlsystems und einer Serviceintervention möglichst lange zu gestalten, können die thermischen Massen (d.h. die Masse multipliziert mit der spezifischen Wärmekapazität) im Kryostaten, etwa eines Strahlungsschildes oder eines Kryobehälters einschließlich kryogener Flüssigkeit, groß gewählt werden, was aber die Bauhöhe und das Gesamtgewicht des Kryostaten vergrößert. Ebenso kann bei Kryostaten mit Kryobehälter extern beschafftes flüssiges Helium nachgefüllt werden, um abgedampftes Helium zu ersetzen; dies ist allerdings sehr teuer.

Aus der US 8,950,194 B2 ist es bekannt geworden, bei abgeschaltetem Kühler etwa während eines Transports einen Teil des abdampfenden Gases aus dem Kryobehälter entlang des Kühlers zu leiten, und so die Wärmelast des Kühlarms zu verringern.

Die US 8,729,894 B2 (=Referenz [2]) beschreibt ein Magnetsystem für ein MRI System, das eine mit dem Kryogentank verbundene Vakuumpumpe umfasst, mit welchem das Kryogen abgepumpt werden kann, um den Druck im Kryogentank zu reduzieren, sodass das Kryogen während des Ladeprozesses abkühlt, um auf ein Temperaturniveau von ca. 2,5K-3K zu kommen. In diesem Magnetsystem ist der gesamte Kryostat mit Kryogen gefüllt. Der Controller für die Pumpe kann gemäß US 8,729,894 B2 beispielsweise ein Druck- oder ein Temperatursensor sein.

Die eingangs zitierte DE 10 2014 218 773 A1 schließlich offenbart ein MCV (minimal condensed volume) System zum Betrieb eines Kryostaten. Das zu kühlende Objekt (die Magnetspule) ist hier trocken, also ohne Helium gelagert. Die kryogene Flüssigkeit, in der Regel flüssiges Helium, befindet sich in einem Hohlvolumen im Halsrohr zwischen dem Kaltkopf und einer Kontaktfläche zum Objekt, wobei sich in Abhängigkeit von Druck und Temperatur ein Gleichgewicht von gasförmigem und flüssigem He ausbildet. Im Normalfall wird der Kryostat bei Normaldruck betrieben. Der Betriebsdruck kann aber auch bei 20 kPa (200mbar) liegen kann, also im Unterdruckbereich gegenüber dem Atmosphärendruck.

Der Betrieb mit flüssigem Helium bei Unterdruck hat den Vorteil, dass die Betriebstemperatur unterhalb von 4,2K liegt, was eine deutlich höhere Auslastung des Supraleiters zur Folge hat. Bei NbTi Leitern verschiebt sich die Ic/B Kurve beispielsweise um 2 bis 3 Tesla zu höheren Feldern, wenn der Leiter von 4,2 auf 2K abgekühlt wird.

Eine Sicherheitseinrichtung, mit welcher bei Ausfall des Kaltkopfs automatisch eine Kühlmaßnahme eingeleitet wird, ist in der DE 10 2014 218 773 A1 nicht beschrieben.

Nachteilig bei allen diskutierten Kryostatenanordnungen aus dem Stand der Technik sind unter anderem die relativ hohe Design-Temperatur, in der Regel um die 4,2K mit welcher eine zu kühlende supraleitende Magnetspule für ihren Betrieb ausgelegt werden muss. Dadurch ergeben sich dann entsprechend höhere Kosten, ein höheres Gewicht sowie größere Abmessungen und meistens eine geringere Zuverlässigkeit bei Strom- oder Kühlwasserausfall.

Ein Beispiel einer Kryostatenanordnung mit den Merkmalen des Oberbegriffs des Anspruchs 1 ist aus der US2009193816 bekannt.

### Aufgabe der Erfindung

Der Erfindung liegt demgegenüber die -im Detail betrachtet relativ anspruchsvolle und komplexe- Aufgabe zugrunde, bei einer Kryostatenanordnung der eingangs beschriebenen Art -insbesondere für einen unterkühlten Betrieb des zu kühlenden Objekts unterhalb von 4,2K- mit unaufwändigen technischen Mitteln und vollautomatisch ohne die Notwendigkeit des Eingreifens einer Bedienungsperson die Wärmelast durch den Kühlkopf auf das zu kühlende Objekt im Falle eines Ausfalls der Kältemaschine betriebssicher und signifikant weiter zu reduzieren, wobei bereits vorhandene Einrichtungen möglichst einfach nachgerüstet werden können. Dabei soll das zu kühlende Objekt für einen möglichst langen Überbrückungszeitraum auf andere Weise automatisch weiter in der Nähe der Betriebstemperatur gehalten werden.

### Kurze Beschreibung der Erfindung

Diese Aufgabe wird durch die vorliegende Erfindung auf ebenso überraschend einfache wie wirkungsvolle Weise dadurch gelöst, dass die Kryostatenanordnung eine Pumpvorrichtung umfasst, an welche der Hohlraum über ein Ventil angeschlossen ist und mit welcher der Hohlraum bei einem Abfall der Kühlfunktion des Kaltkopfs auspumpbar ist, und dass eine Überwachungseinrichtung vorhanden ist, die die Kühlfunktion des Kaltkopfs überwacht, und die dazu ausgebildet ist, bei Abfall der Kühlfunktion des Kaltkopfs die Pumpvorrichtung selbsttätig so zu aktivieren, dass der Hohlraum abgepumpt wird.

Damit kann -insbesondere bei einer Betriebstemperatur von ca. 3K- in einen CF(=cryogen free) System während des Ladevorgangs und bei Ausfall des Kühlsystems die notwendige Kühlung des zu kühlenden Objekts zumindest während eines ganz erheblich verlängerten Überbrückungszeitraums aufrecht erhalten werden. Dadurch wird es ermöglicht, die Designtemperatur einer zu kühlenden Magnetspule signifikant zu senken und somit erheblich Kosten einzusparen. Durch die vorliegende Erfindung wird ein Sicherheitssystem für Kryostaten bereitgestellt, mit welchem es möglich ist, durch Aufrechterhaltung eines niedrigen Drucks in einem Bereich des Kryostaten, in welchem ein flüssiges Kryogen vorhanden ist, den Übergang in die Gasphase zu verbessern und somit die Verdampfungswärme zu nutzen, um den Kryostaten unterkühlt zu halten. Vorzugsweise wird dieses System bei der MCV-(=minimal condensed volume)-Variante eingesetzt, wobei das Kryogen in einem Hohlvolumen zwischen dem zu kühlenden Objekt und dem Halsrohrbereich abgepumpt wird. Durch die damit verbundene Reduzierung des Wärmeeintrags verlängert sich die Zeit bis die Magnetspule bei Ausfall des aktiven Kühlers ihre kritische Temperatur erreicht und normalleitend wird erheblich. Diese Zeitspanne ist eine wesentliche Spezifikation von supraleitendenden Magneten.

### Bevorzugte Ausführungsformen und Weiterbildungen der Erfindung

Ganz besonders bevorzugt ist eine Klasse von Ausführungsformen der erfindungsgemäßen Kryostatenanordnung, welche sich dadurch auszeichnet, dass ein Drucksensor mit dem Hohlraum strömungstechnisch verbunden, insbesondere im Hohlraum angeordnet ist, dessen Ausgangssignal in die Überwachungseinrichtung eingespeist wird, und dass die Überwachungseinrichtung die Pumpvorrichtung zum Abpumpen des Hohlraums aktiviert, sobald das Ausgangssignal des Drucksensors einen vorgegebenen ersten Schwellenwert Pₘₐₓ überschreitet, wobei 100mbar ≤ Pₘₐₓ ≤ 500mbar. , wobei 1 mbar = 0.1kPa. Hierdurch wird verhindert, dass schon bei sehr kurzen Ausfällen (< 15min) kryogenes Fluid abgepumpt wird, da es eine gewisse Zeit dauert, bis der Druck vom Betriebsdruck auf dem Schwellenwert ansteigt.

Der Druck korreliert direkt mit der gewünschten Temperatur im Hohlraum. Wenn der Druck auf den angegebenen Bereich gemindert wird, sinkt die Temperatur im Hohlraum entsprechend. Geht man beispielsweise vom P/T Diagramm von Helium als kryogenem Fluid aus, so ist erkennbar, dass ein Druck von 240mbar einer Temperatur von ca. 3K entspricht und bei einem Druck von 100mbar wäre die resultierende Temperatur etwa 2,5K.

Des Weiteren ist ein Drucksensor kostengünstig und kann im Dauerbetrieb zuverlässig eingesetzt werden.

Bei vorteilhaften Weiterbildungen dieser Klasse von Ausführungsformen pumpt die Pumpvorrichtung nach ihrer Aktivierung aufgrund eines Überschreiten des ersten Schwellenwerts Pₘₐₓ den Hohlraum nur solange ab, bis das Ausgangssignal des Drucksensors einen vorgegebenen zweiten Schwellenwert Pₘᵢₙ unterschreitet, wobei insbesondere 75mbar ≤ Pₘᵢₙ ≤ 300mbar.

Für diese Zweipunktregelung gilt Pₘᵢₙ < Pₘₐₓ. Mit dieser Art der Abschaltvorrichtung ist gewährleistet, dass das kryogene Fluid nicht weiter abgepumpt wird und somit die Dauer des Kühlvorgangs durch auspumpen des Hohlraums bei Ausfall der Kühlfunktion nicht mehr als notwendig verkürzt wird. Wenn die Kühlfunktion wieder einsetzt, bedarf es ebenfalls einer Abschaltvorrichtung, welche die Pumpvorrichtung deaktiviert.

Bei einer weiteren vorteilhaften Ausführungsform der erfindungsgemäßen Kryostatenanordnung ist das ansteuerbare Ventil als Regelventil ausgeführt.

Dadurch lässt sich der Druck im Hohlraum exakt regeln. Der Abpumpvorgang kann so optimiert werden, dass die gewünschte Zieltemperatur genau eingehalten wird. Dadurch wird einerseits vermieden, dass der verfügbare Heliumvorrat zu schnell abgepumpt wird (dies würde die Haltezeit verringern), anderseits wird auch sichergestellt, dass sich die Spule nicht unzulässig erwärmt.

Bei besonders einfachen Weiterbildungen dieser Ausführungsform ist die Pumpvorrichtung so gestaltet, dass sie mit konstanter Geschwindigkeit und/oder Pumpleistung betrieben werden kann.

Derartige Pumpen sind weit verbreitet und besonders billig und zuverlässig.

Bei einer weiteren Klasse von bevorzugten Ausführungsformen der Erfindung ist die Pumpvorrichtung so gestaltet, dass sie mit variabler, vorzugsweise einstellbarer, Geschwindigkeit und/oder Pumpleistung betrieben werden kann. Eine solche Lösung würde in Kombination mit einem on/off Ventil (bzw. vielleicht auch ganz ohne automatisches Ventil) gewählt werden. Die Geschwindigkeit der Pumpe zu regulieren, ist energetisch besonders günstig, da es zu keinen Drosselverlusten in einem halb geöffneten Regelventil kommt. Außerdem ist die Regelung des Durchflusses durch Variierung der Pumpengeschwindigkeit genauer als die Regelung mittels eines Regelventils.

Diese Ausführungsformen können bei wiederum ziemlich einfach gestalteten Weiterbildungen mit einem EIN/AUS-Ventil als ansteuerbarem Ventil ausgestattet sein.

Derartige Ventile sind weit verbreitet und besonders preisgünstig und zuverlässig.

Um das durch die Erfindung bereitgestellte Sicherheitssystem möglichst autark zu gestalten, sodass es auch bei Ausfall der Stromversorgung anspringen kann, umfasst bei besonders bevorzugten Ausführungsformen der erfindungsgemäßen Kryostatenanordnung die Pumpvorrichtung eine mittels einer autarken Stromquelle, vorzugsweise mittels einer Batterie, gepufferte, elektrisch betriebene Saugpumpe.

Alternativ kann statt einer mechanischen Pumpe auch eine kryogen gekühlte Sorptionspumpe zum Einsatz kommen, die im Betrieb gar keinen Strom benötigt und vollkommen passiv funktioniert. Eine solche Kryopumpe wird vorzugsweise in die Kryostatenanordnung integriert, um einen möglichst kompakten Aufbau zu erreichen.

Im Falle der Verwendung einer Kryopumpe als Pumpvorrichtung, muss diese nicht gesondert aktiviert werden, da sie permanent aktiv ist. Es genügt das Öffnen des Ventils zur Aktivierung der Kryopumpe.

Die pumpenden Kaltflächen der Kryopumpe werden vorzugsweise thermisch an das zu kühlende Objekt gekoppelt, insbesondere wobei eine Verbindungsleitung vom Hohlraum zu den pumpenden Kaltflächen vollständig innerhalb des Vakuumbehälters verläuft.

Eine Kryopumpe hat keine beweglichen Teile, weshalb sie besonders zuverlässig ist. Außerdem funktioniert sie ohne Zufuhr elektrischer Energie, d.h. auf eine Batterie kann verzichtet werden.

Um die erfindungsgemäße Kryostatenanordnung möglichst autark zu gestalten, ist es zweckmäßig, wenn nach dem Ausfall der Kühlfunktion die Möglichkeit besteht, den Verlust an kryogenem Fluid wieder aufzufüllen. Vorzugsweise umfasst daher die Kryostatenanordnung eine Zufuhrleitung, welche an den Hohlraum angeschlossen ist, sodass bei Wiederinbetriebnahme der Kühlfunktion der Verlust an kryogenem Fluid wiederbefüllbar ist.
Vorteilhaft ist es, wenn die Zufuhrleitung mit einem Druckminderer ausgestattet ist. Zum einen kann der Befüllvorgang kontrolliert durchgeführt werden, ohne dass ein Überdruck entsteht, denn üblicherweise wird das kryogene Fluid in gasförmigem Zustand eingebracht, wobei es am Kaltkopf abkondensieren kann. Wenn das kryogene Fluid aus dem Außenbereich zugeführt wird, hat es möglicherweise eine deutlich höhere Temperatur, als im Kryostaten gewünscht, daher ist eine kontrollierte Zufuhr vorteilhaft.

In den Rahmen der vorliegenden Erfindung fällt auch ein Verfahren zum Betrieb einer Kryostatenanordnung, insbesondere einer erfindungsgemäßen, oben beschriebenen Kryostatenanordnung, mit einem Vakuumbehälter und einem zu kühlenden Objekt, insbesondere einem supraleitenden Magnetspulensystem oder einem Kryobehälter, wobei das zu kühlende Objekt innerhalb des Vakuumbehälters angeordnet ist, wobei der Vakuumbehälter ein Halsrohr aufweist, das zum zu kühlenden Objekt führt, wobei ein Kühlarm eines Kaltkopfs zumindest teilweise im Halsrohr angeordnet ist, wobei um den Kühlarm herum ein abgeschlossener Hohlraum ausgebildet ist, der gegenüber dem zu kühlenden Objekt fluiddicht abgedichtet ist, wobei der Hohlraum im Normalbetrieb zumindest teilweise mit einem kryogenen Fluid gefüllt ist, und wobei ein thermisches Kopplungsmittel vorgesehen ist, geeignet zur thermischen Kopplung des kryogenen Fluids im Hohlraum mit dem zu kühlenden Objekt. Das erfindungsgemäße Verfahren ist dadurch gekennzeichnet, dass bei Ausfall der Kühlfunktion des Kaltkopfs der Hohlraum über eine Pumpvorrichtung derart abgepumpt wird, dass der Druck im Hohlraum einen vorgegebenen ersten Schwellenwert Pₘₐₓ nicht überschreitet.

Ganz besonders bevorzugt ist eine Variante des erfindungsgemäßen Verfahrens, bei welcher der Hohlraum über eine Pumpvorrichtung derart abgepumpt wird, dass der Druck im Hohlraum einen vorgegebenen zweiten Schwellenwert Pₘᵢₙ < Pₘₐₓ nicht unterschreitet.

Vorteilhaft sind auch Weiterbildungen des erfindungsgemäßen Verfahrens, bei denen als kryogenes Fluid Helium verwendet wird, und dass die Pumpvorrichtung derart betrieben wird, dass im Normalbetrieb der Druck im Hohlraum zwischen 100mbar und 500mbar, insbesondere zwischen 150mbar und 350mbar, vorzugsweise zwischen 200mbar und 300mbar beträgt.

Eine hohe Betriebssicherheit bietet eine alternative Verfahrensvariante zum Betrieb einer Kryostatenanordnung mit einer ansteuerbaren Pumpvorrichtung, an welche der Hohlraum über ein ansteuerbares Ventil angeschlossen ist, sowie mit einer Überwachungs-einrichtung, die Kühlfunktion des Kaltkopfs und/oder den Druck im Hohlraum überwacht, welche dadurch gekennzeichnet ist, dass die Überwachungs-einrichtung bei Abfall der Kühlfunktion des Kaltkopfs und/oder bei Überschreiten des Druckes im Hohlraum über den vorgegebenen ersten Schwellenwert Pₘₐₓ die die Pumpvorrichtung so aktiviert, dass der Hohlraum auf einen Druck unterhalb des Schwellenwerts Pₘₐₓ abgepumpt wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen schematischen Querschnitt einer ersten Ausführungsform einer erfindungsgemäßen Kryostatenanordnung mit einer supraleitenden Magnetspule unmittelbar im Vakuum als zu kühlendem Objekt;
- Fig. 2: einen schematischen Querschnitt einer zweien Ausführungsform der erfindungsgemäßen Kryostatenanordnung mit einem Kryobehälter als zu kühlendem Objekt, wobei im Kryobehälter eine supraleitende Magnetspule enthalten ist;
- Fig. 3: einen schematischen Querschnitt einer dritten Ausführungsform der erfindungsgemäßen Kryostatenanordnung im Bereich des Halsrohres mit einem an den Hohlraum strömungstechnisch angeschlossenen Drucksensor;
- Fig. 4: einen schematischen Ausschnitt einer vierten Ausführungsform der erfindungsgemäßen Kryostatenanordnung mit einer Kryopumpe; und
- Fig. 5: ein schematisches Zeitdiagramm der Erwärmung einer Kryostatenanordnung nach dem Stand der Technik im Vergleich zu einer erfindungsgemäßen Kryostatenanordnung ausgehend von einer ursprünglichen Betriebstemperatur von 3K nach dem Ausfall der Kühleinrichtung.

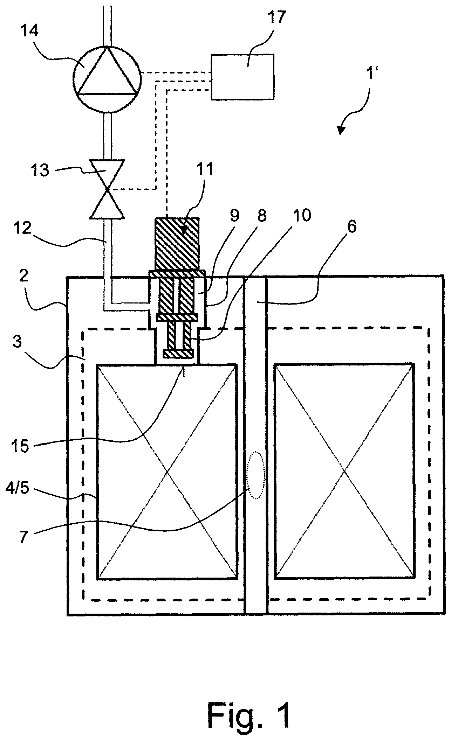

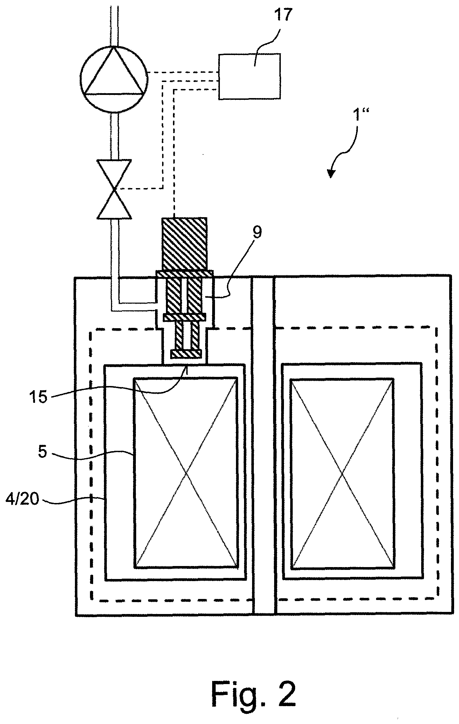

Die Figuren 1 und 2 zeigen jeweils in einer schematischen Vertikalschnittansicht Ausführungsformen der erfindungsgemäßen **Kryostatenanordnung 1'; 1"; 1"'; 1""** mit einem **Vakuumbehälter 2** und einem **zu kühlenden Objekt 4** (insbesondere einem supraleitfähigen **Magnetspulensystem 5** in einer NMR-, MRI- oder FTMS-Apparatur), wobei das zu kühlende Objekt 4 innerhalb des Vakuumbehälters 2 angeordnet ist, wobei der Vakuumbehälter 2 ein **Halsrohr 8** aufweist, das zum zu kühlenden Objekt 4 führt, wobei ein **Kühlarm 10** eines **Kaltkopfs 11** zumindest teilweise im Halsrohr 8 angeordnet ist, wobei um den Kühlarm 10 herum ein abgeschlossener **Hohlraum 9** ausgebildet ist, der gegenüber dem zu kühlenden Objekt 4 fluiddicht abgedichtet ist, wobei der Hohlraum 9 im Normalbetrieb zumindest teilweise mit einem kryogenen Fluid gefüllt ist, und wobei ein **thermisches Kopplungsmittel 15** vorgesehen ist, geeignet zur thermischen Kopplung des kryogenen Fluids im Hohlraum 9 mit dem zu kühlenden Objekt 4.

Die erfindungsgemäße Kryostatenanordnung 1'; 1"; 1'''; 1'''' zeichnet sich dadurch aus, dass sie eine ansteuerbare **Pumpvorrichtung 14** umfasst, an welche der Hohlraum 9 über ein ansteuerbares **Ventil 13** angeschlossen ist und mit welcher der Hohlraum 9 bei einem Abfall der Kühlfunktion des Kaltkopfs 11 auspumpbar ist, und dass eine **Überwachungseinrichtung 17** vorhanden ist, die die Kühlfunktion des Kaltkopfs 11 überwacht, und die dazu ausgebildet ist, bei Abfall der Kühlfunktion des Kaltkopfs 11 die Pumpvorrichtung 14 selbsttätig so zu aktivieren, dass der Hohlraum 9 abgepumpt wird.

**Fig. 1** zeigt schematisch eine erste Ausführungsform einer erfindungsgemäßen Kryostatenanordnung 1', umfassend einen Vakuumbehälter 2, in dessen Innerem ein Vakuum eingerichtet ist. Im Vakuumbehälter 2 ist hier ein thermischer Strahlungsschild 3 (gestrichelt gezeichnet) angeordnet, der hier als zu kühlendes Objekt 4 ein supraleitendes Magnetspulensystem 5 umgibt. Das Magnetspulensystem 5 ist hier unmittelbar im Vakuum des Vakuumbehälters 2 angeordnet.

Die Kryostatenanordnung 1' ist mit einer Raumtemperaturbohrung 6 versehen, durch das ein Probenvolumen 7 im Zentrum des Magnetspulensystems 5 zugänglich ist. Im Probenvolumen 7 herrscht ein starkes, statisches, annähernd homogenes Magnetfeld B₀, das für NMR-Messungen an einer Probe im Probenvolumen 7 mit nicht näher dargestellten NMR-Resonatoren genutzt werden kann.

Durch den Vakuumbehälter 2 führt ein Halsrohr 8 zum zu kühlenden Objekt 4. In der gezeigten Ausführungsform bildet das Halsrohr 8 gleichzeitig die Einfassung eines Hohlraums 9, der einen Kühlarm 10 eines Kühlkopfs 11 eines aktiven Kühlsystems der Kryostatenanordnung 1' unmittelbar umgibt.

Der Hohlraum 9 ist über eine Pumpleitung 12 und ein Ventil 13, insbesondere ein Absperrventil, an eine Pumpvorrichtung 14 angeschlossen, mit der der Hohlraum 9 evakuiert werden kann. Zur Ansteuerung des Ventils 13 und der Pumpvorrichtung 14 ist eine Überwachungseinrichtung 17 vorgesehen, die auch (direkte oder implizite) Temperaturinformationen vom Kühlkopf 11 erhält, und hier bei Überschreiten einer Grenztemperatur selbsttätig das Ventil 13 öffnet und die Pumpvorrichtung 14 aktiviert.

Während eines Normalbetriebs der Kryostatenanordnung 1' ist der Hohlraum 9 zumindest teilweise mit einem kryogenen Fluid (in der Zeichnung nicht näher dargestellt) gefüllt, das den Kühlarm 10 mit dem zu kühlenden Objekt 4 über ein thermisches Kopplungsmittel 15 koppelt. Das thermische Kopplungsmittel 15 ist hier eine Oberseite des zu kühlenden Objekts 4, die gleichzeitig einen Teil der Einfassung des Hohlraums 9 bildet. Im Falle einer Störung der aktiven Kühlung des Kühlarms 10 wird der Hohlraum 9 mit der Pumpvorrichtung 14 abgepumpt und damit das kryogene Fluid im Hohlraum 9 abgekühlt.

**Fig. 2** zeigt eine zweite Ausführungsform einer erfindungsgemäßen Kryostatenanordnung 1", die weitgehend der ersten Ausführungsform von Fig. 1 entspricht; es werden daher nur die wesentlichen Unterschiede erläutert.

In der zweiten Ausführungsform ist das zu kühlende Objekt 4 als ein Kryobehälter 20 ausgebildet, innerhalb dessen ein supraleitendes Magnetspulensystem 5 angeordnet ist. Weiterhin ist im Kryobehälter 20 ein zweites kryogenes Fluid, hier teilweise flüssiges und teilweise gasförmiges Helium (in der Zeichnung wiederum nicht näher dargestellt), angeordnet. Das supraleitende Magnetspulensystem 5 ist typischerweise zumindest teilweise in das flüssige Helium eingetaucht. Die thermische Koppeleinrichtung 15 wird hier durch einen Teil der oberseitigen der Kryobehälterwand ausgebildet, die gleichzeitig den Hohlraum 9 begrenzt.

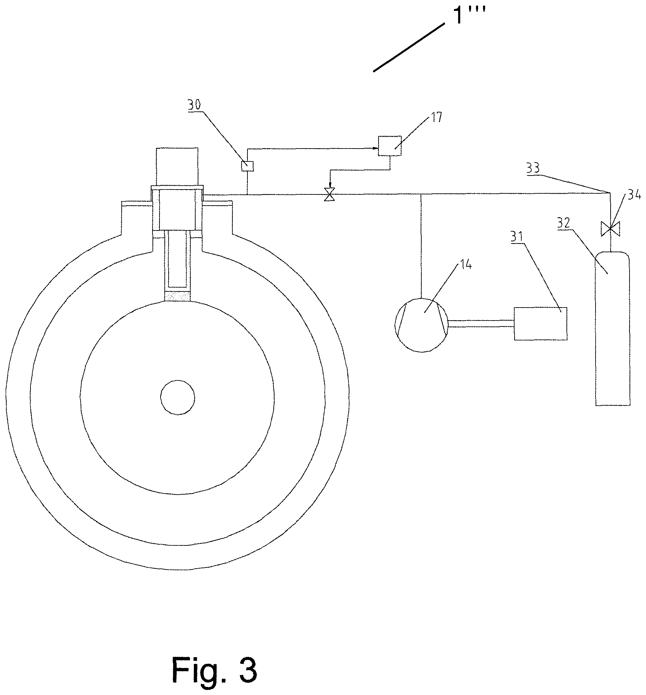

**Fig. 3** zeigt eine dritte Ausführungsform der erfindungsgemäßen Kryostatenanordnung 1''' im Bereich des Halsrohres 8. Bei dieser -bevorzugten-Ausführungsform ist ein **Drucksensor 30** mit dem Hohlraum 9 strömungstechnisch verbunden. Bei in der Zeichnung nicht eigens dargestellten Weiterbildungen kann der Drucksensor insbesondere direkt im Hohlraum 9 angeordnet sein. Das Ausgangssignal des Drucksensors 30 wird in die Überwachungseinrichtung 17 eingespeist, welche die Pumpvorrichtung 14 zum Abpumpen des Hohlraums 9 aktiviert, sobald das Ausgangssignal des Drucksensors 30 einen vorgegebenen ersten Schwellenwert Pₘₐₓ überschreitet, wobei insbesondere 100mbar ≤ Pₘₐₓ ≤ 500mbar. Nach ihrer Aktivierung aufgrund eines Überschreiten des ersten Schwellenwerts Pₘₐₓ pumpt die Pumpvorrichtung 14 den Hohlraum 9 nur solange ab, bis das Ausgangssignal des Drucksensors 30 einen vorgegebenen zweiten Schwellenwert Pₘᵢₙ unterschreitet, wobei insbesondere 75mbar ≤ Pₘᵢₙ ≤ 300mbar.

Bei dieser Ausführungsform der erfindungsgemäßen Kryostatenanordnung 1''' umfasst die Pumpvorrichtung 14 eine mittels einer autarken Stromquelle, vorzugsweise mittels einer **Batterie 31,** gepufferte, elektrisch betriebene Saugpumpe.

Weiterhin umfasst diese Ausführungsform der erfindungsgemäßen Kryostatenanordnung eine Vorrichtung zum Wiederbefüllen des Hohlraums 9 mit dem kryogenen Fluid. Diese Vorrichtung umfasst einen **Vorratsbehälter 32** mit dem kryogenen Fluid sowie eine **Zufuhrleitung 33,** welche den Behälter 32 mit dem Hohlraum verbindet. Mit dieser Vorrichtung kann ein möglichst autarker Betrieb auch nach dem Ausfall der Kühlvorrichtung gewährleistet werden, da die Möglichkeit besteht, den Verlust an kryogenem Fluid wieder aufzufüllen. Vorteilhaft ist es, wenn die Zufuhrleitung 33 mit einem **Druckminderer 34** ausgestattet ist. So kann der Befüllvorgang kontrolliert durchgeführt werden, ohne dass ein Überdruck entsteht.

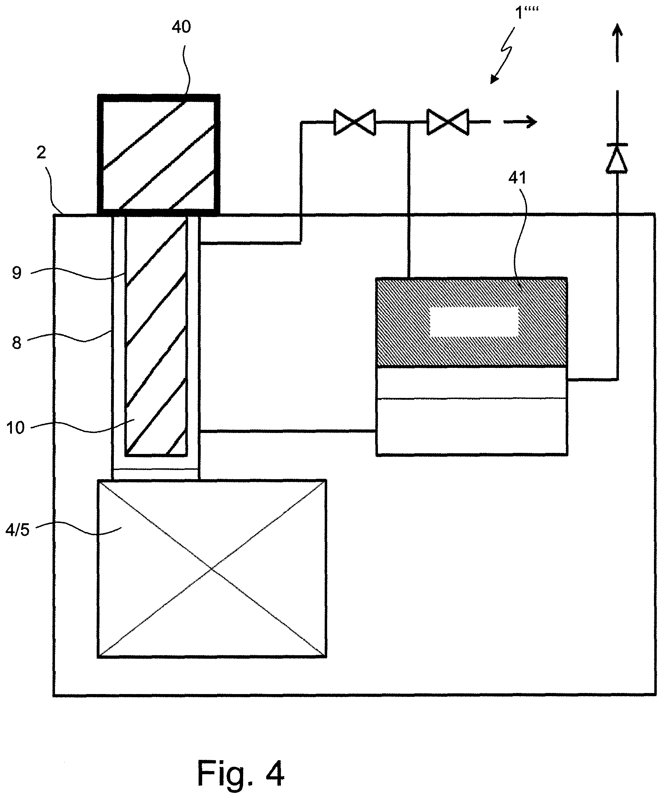

**Fig. 4** zeigt eine vierte Ausführungsform der erfindungsgemäßen Kryostatenanordnung 1''''. Hier umfasst die Pumpvorrichtung - statt einer elektrisch betriebenen Pumpe- eine **Kryopumpe 40,** die vorzugsweise in die Kryostatenanordnung 1'''' integriert ist. Der Vorteil einer Kryopumpe 40 besteht darin, dass diese komplett passiv und daher sehr zuverlässig ausgeführt werden kann.

In einer Kryopumpe wird ein geeignetes **Adsorptionsmaterial 41** -z.B. Aktivkohle- abgekühlt. Bei einer Temperatur von 4,2K kann so selbst Helium gepumpt werden. Wie in Fig. 4 gezeigt, kann die Kryopumpe 40 direkt in den Magnetkryostaten integriert werden. Die Pumpe wird mit einer geringen Menge flüssigen Heliums betrieben, das in der Zeichnung unterhalb des Adsorptionsmaterials 41 angedeutet ist. Das Helium kann, da es eine Temperatur von 4,2K hat, in die Atmosphäre (1000mbar) verdampfen. Die Kryopumpe 40 darf thermisch nicht gut an den Kaltkopf angekoppelt werden, da beim Pumpen von Helium mit der Kryopumpe 40 Wärme frei wird, die ansonsten zur Erwärmung des Magnetspulensystems 5 beitragen würde.

Ein wesentlicher Zweck der vorliegenden Erfindung ist die Bereitstellung eines Kryomagneten, welcher gegenüber dem herkömmlichen Betrieb bei 4,2K (entspricht dem Siedepunkt von He bei Normaldruck) beispielsweise bei 3K (entspricht einem Druck von ca. 240mbar) betrieben wird. Durch diese geringfügige Absenkung der Temperatur steigt im Supraleiter z.B. NbTi die Stromtragfähigkeit, sodass das Design eines deutlich kompakteren Magneten möglich wird. Gemäß hier nicht gezeigter Simulationen kann somit ein Magnet mit einer Flussdichte von 9,4T von etwa 900kg auf 600kg Supraleiter reduziert werden, weil dieser mit höheren Stromdichten beschickt werden kann.

Nachteilig hierbei ist, dass der Supraleiter sensibler auf einen Wärmeeintrag ist, und es bei niedrigerer Temperatur (etwa 4-5K) bereits zum Quench kommt. Es bedarf also einer Sicherheitseinrichtung, mit welcher gewährleistet werden kann, dass bei Ausfall des Kühlkopfes die Temperatur des Kryostaten möglichst lange bei 3K gehalten werden kann.

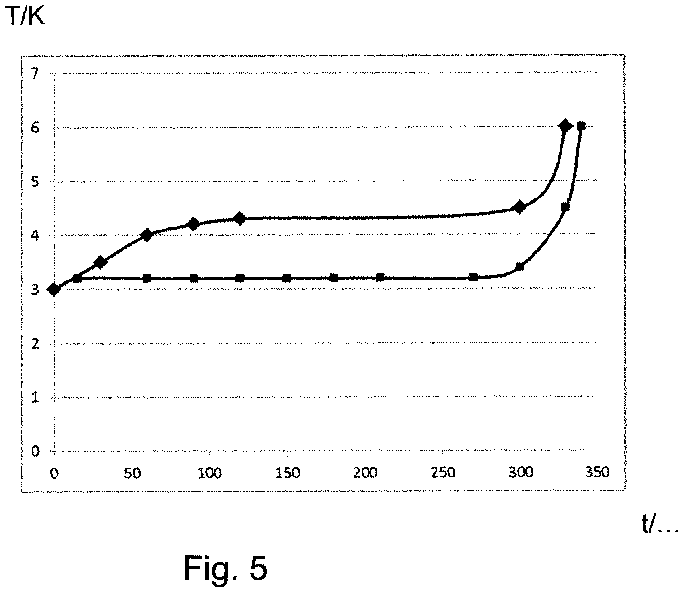

In dem in **Fig. 5** gezeigten Diagramm ist beispielhaft zu erkennen wie sich die Temperaturkurve des He beim Ausfall des Kühlkopfes als Funktion der Zeit entwickelt. Als Beispiel kann der MCV-Kryostat aus dem eingangs zitierten Stand der Technik (DE 10 2014 218 773 A1) dienen (Linie mit Rautensymbolen). Nach dem Ausfall steigt die Temperatur bis zum Siedepunkt bei Normaldruck, wo die Temperatur eine Plateauphase hat, bis der flüssige Anteil des He in die Gasphase übergegangen ist. Danach steigt die Temperatur kontinuierlich weiter bis zum Quench.

Aufgrund der vorliegenden Erfindung (Linie mit Quadratsymbolen) steigt die Temperatur nur solange an bis der Grenzdruck (300mbar / 3,2K) erreicht wird. Anschließend beginnt die Pumpe Gas abzupumpen um das Bad durch Verdampfen auf dieser Temperatur zu halten. Ist das gesamte Helium verdampft, steigt die Temperatur und ein Quench wird unvermeidlich, wenn der Kühlkopf noch länger ausfällt.

Um die Temperatur auf diese Art bei den beispielhaft genannten 3K zu halten, ist ein Drucksensor 30 notwendig, wie er in Fig. 3 dargestellt ist. Dieser Drucksensor 30 misst im Falle steigender Temperatur die damit verbundene Druckzunahme im Hohlvolumen 9, wo sich das Kryogen (He) befindet, und gibt den Messwert an die Überwachungseinrichtung 17 weiter, welche bei Überschreiten eines Schwellenwerts Pₘₐₓ die Pumpvorrichtung 14 ansteuert, die dann aus dem Hohlvolumen 9 das Kryogen aus der Gasphase entfernt bis zu dem gewünschten (Unter-) Druck. Bei der genauen Regelung des Unterdrucks ist ein Regelventil 13 (oder eine Pumpe mit variabler Geschwindigkeit) von Vorteil.

Während des Ladens oder nach Ausfall des PT schaltet sich bei Überschreiten des einstellbaren Druck- Schwellenwerts Pₘₐₓ im Halsrohr 8 die batteriegepufferte Pumpvorrichtung 14 ein und hält den Druck mittels Regelung, Drucksensor 30 und Regelventil 13 durch Abpumpen von Helium stabil. Der Druck liegt etwas oberhalb des Drucks im Normalbetrieb. Beispiel Normalbetrieb 180mbar. Regeldruck 300mbar (entspricht 3,2K).

### Bezugszeichenliste

- 1'; 1"; 1'''; 1'''': Kryostatenanordnung
- 2: Vakuumbehälter
- 3: Thermischer Strahlungsschild
- 4: zu kühlendes Objekt
- 5: supraleitendes Magnetspulensystem
- 6: Raumtemperaturbohrung
- 7: Probenvolumen
- 8: Halsrohr
- 9: Hohlraum
- 10: Kühlarm
- 11: Kaltkopf (=Kühlkopf)
- 12: Pumpleitung
- 13: Ventil
- 14: Pumpvorrichtung
- 15: thermisches Kopplungsmittel
- 17: Überwachungseinrichtung
- 20: Kryobehälter
- 30: Drucksensor
- 31: Batterie
- 32: Vorratsbehälter
- 33: Zufuhrleitung
- 34: Druckminderer
- 40: Kryopumpe
- 41: Adsorptionsmaterial

### Referenzliste

Für die Beurteilung der Patentfähigkeit in Betracht gezogene Publikationen:
[1] DE 10 2014 218 773 A1
[2] US 8,729,894 B2
[3] US 2007/089432 A
[4] US 2010/298148 A
[5] US 2007/022761A
[6] DE 10 2004 012 416 B4
[7] US 2007/051115 A
[8] US 8,950,194 B2

## Patentansprüche

1. Kryostatenanordnung (1'; 1"; 1'''; 1''''), mit einem Vakuumbehälter (2) und einem zu kühlenden Objekt (4), wobei das zu kühlende Objekt (4) innerhalb des Vakuumbehälters (2) angeordnet ist, wobei der Vakuumbehälter (2) ein Halsrohr (8) aufweist, das zum zu kühlenden Objekt (4) führt, wobei ein Kühlarm (10) eines Kaltkopfs (11) zumindest teilweise im Halsrohr (8) angeordnet ist, wobei um den Kühlarm (10) herum ein abgeschlossener Hohlraum (9) ausgebildet ist, der gegenüber dem zu kühlenden Objekt (4) fluiddicht abgedichtet ist, wobei der Hohlraum (9) im Normalbetrieb zumindest teilweise mit einem kryogenen Fluid gefüllt ist, und wobei ein thermisches Kopplungsmittel (15) vorgesehen ist, geeignet zur thermischen Kopplung des kryogenen Fluids im Hohlraum (9) mit dem zu kühlenden Objekt (4), wobei die Kryostatenanordnung (1'; 1"; 1'''; 1'''') eine Pumpvorrichtung (14) umfasst, an welche der Hohlraum (9) über ein ansteuerbares Ventil (13) angeschlossen ist und mit welcher der Hohlraum (9) bei einem Abfall der Kühlfunktion des Kaltkopfs (11) auspumpbar ist,
und dass eine Überwachungseinrichtung (17) vorhanden ist, die die Kühlfunktion des Kaltkopfs (11) überwacht, und die dazu ausgebildet ist, bei Abfall der Kühlfunktion des Kaltkopfs (11) die Pumpvorrichtung (14) selbsttätig so zu aktivieren, dass der Hohlraum (9) abgepumpt wird,
**dadurch gekennzeichnet,**
**dass** ein Drucksensor (30) mit dem Hohlraum (9) strömungstechnisch verbunden ist, dessen Ausgangssignal in die Überwachungseinrichtung (17) einspeisbar ist, und dass die Überwachungseinrichtung (17) so ausgelegt ist, dass sie die Pumpvorrichtung (14) zum Abpumpen des Hohlraums (9) aktiviert, sobald das Ausgangssignal des Drucksensors (30) einen vorgegebenen ersten Schwellenwert Pₘₐₓ von 10kPa (100mbar) ≤ Pₘₐₓ ≤ 50kPa (500mbar) überschreitet.

2. Kryostatenanordnung nach Anspruch 1, **dadurch gekennzeichnet, dass** der Drucksensor (30) im Hohlraum (9) angeordnet ist.

3. Kryostatenanordnung nach Anspruch 2, **dadurch gekennzeichnet, dass** die Pumpvorrichtung (14) nach ihrer Aktivierung aufgrund eines Überschreiten des ersten Schwellenwerts Pₘₐₓ den Hohlraum (9) nur solange abpumpt, bis das Ausgangssignal des Drucksensors (30) einen vorgegebenen zweiten Schwellenwert Pₘᵢₙ unterschreitet, wobei 7.5kPa (75mbar) ≤ Pₘᵢₙ ≤ 30kPa (300mbar).

4. Kryostatenanordnung nach einem der vorhergehenden Ansprüche,
**dadurch gekennzeichnet, dass** das ansteuerbare Ventil (13) als Regelventil ausgeführt ist.

5. Kryostatenanordnung nach Anspruch 4, **dadurch gekennzeichnet, dass** die Pumpvorrichtung (14) so gestaltet ist, dass sie mit konstanter Geschwindigkeit und/oder Pumpleistung betrieben wird.

6. Kryostatenanordnung nach einem der Ansprüche 1 bis 4, **dadurch gekennzeichnet, dass** die Pumpvorrichtung (14) so gestaltet ist, dass sie mit variabler, einstellbarer, Geschwindigkeit und/oder Pumpleistung betrieben werden kann.

7. Kryostatenanordnung nach Anspruch 6, **dadurch gekennzeichnet, dass** das ansteuerbare Ventil (13) als EIN/AUS-Ventil ausgeführt ist.

8. Kryostatenanordnung nach einem der Ansprüche 1 bis 7, **dadurch gekennzeichnet, dass** die Pumpvorrichtung (14) eine mittels einer autarken Stromquellegepufferte, elektrisch betriebene Saugpumpe umfasst.

9. Kryostatenanordnung nach einem der Ansprüche 1 bis 7, **dadurch gekennzeichnet, dass** die Pumpvorrichtung (14) eine Kryopumpe (40) umfasst, die in die Kryostatenanordnung integriert ist.

10. Kryostatenanordnung nach Anspruch 9, **dadurch gekennzeichnet, dass** die pumpende Kaltflächen der Kryopumpe (40) thermisch an das zu kühlende Objekt (4) gekoppelt sind, wobei eine Verbindungsleitung vom Hohlraum (9) zu den pumpenden Kaltflächen vollständig innerhalb des Vakuumbehälters (2) verläuft.

11. Kryostatenanordnung nach einem der vorhergehenden Ansprüche,
**dadurch gekennzeichnet, dass** eine Zufuhrleitung (33) mit dem Hohlraum (9) strömungstechnisch verbunden ist, mit welcher der Hohlraum (9) nach wieder Inbetriebnahme der Kühlfunktion den Hohlraum (9) mit kryogenem Fluid wiederbefüllbar ist.

12. Verfahren zum Betrieb einer Kryostatenanordnung (1'; 1"; 1'''; 1'''') nach einem der vorhergehenden Ansprüche, mit einem Vakuumbehälter (2) und einem zu kühlenden Objekt (4), wobei das zu kühlende Objekt (4) innerhalb des Vakuumbehälters (2) angeordnet ist, wobei der Vakuumbehälter (2) ein Halsrohr (8) aufweist, das zum zu kühlenden Objekt (4) führt, wobei ein Kühlarm (10) eines Kaltkopfs (11) zumindest teilweise im Halsrohr (8) angeordnet ist, wobei um den Kühlarm (10) herum ein abgeschlossener Hohlraum (9) ausgebildet ist, der gegenüber dem zu kühlenden Objekt (4) fluiddicht abgedichtet ist, wobei der Hohlraum (9) im Normalbetrieb zumindest teilweise mit einem kryogenen Fluid gefüllt ist, und wobei ein thermisches Kopplungsmittel (15) vorgesehen ist, geeignet zur thermischen Kopplung des kryogenen Fluids im Hohlraum (9) mit dem zu kühlenden Objekt (4),
**dadurch gekennzeichnet,**
**dass** der Hohlraum (9) über eine Pumpvorrichtung (14) derart abgepumpt wird, dass der Druck im Hohlraum (9) einen vorgegebenen ersten Schwellenwert Pₘₐₓ von 10kPa (100mbar) ≤ Pₘₐₓ ≤ 50kPa (500mbar) nicht überschreitet.

13. Verfahren nach Anspruch 12, **dadurch gekennzeichnet, dass** der Hohlraum (9) über eine Pumpvorrichtung (14) derart abgepumpt wird, dass der Druck im Hohlraum (9) einen vorgegebenen zweiten Schwellenwert Pₘᵢₙ < Pₘₐₓ nicht unterschreitet.

14. Verfahren nach einem der Ansprüche 12 oder 13, **dadurch gekennzeichnet, dass** als kryogenes Fluid Helium verwendet wird, und dass die Pumpvorrichtung (14) derart betrieben wird, dass im Normalbetrieb der Druck im Hohlraum (9) zwischen 15kPa (150mbar) und 35kPa (350mbar) beträgt.

15. Verfahren nach einem der Ansprüche 12 bis 14 zum Betrieb der Kryostatenanordnung (1'; 1"; 1'''; 1'''') mit der ansteuerbaren Pumpvorrichtung (14), an welche der Hohlraum (9) über das ansteuerbares Ventil (13) angeschlossen ist, sowie mit der Überwachungseinrichtung (17, die die Kühlfunktion des Kaltkopfs (11) und/oder den Druck im Hohlraum (9) überwacht, **dadurch gekennzeichnet, dass** die Überwachungseinrichtung (17) bei Abfall der Kühlfunktion des Kaltkopfs (11) und/oder bei Überschreiten des Druckes im Hohlraum (9) über den vorgegebenen ersten Schwellenwert Pₘₐₓ die die Pumpvorrichtung (14) so aktiviert, dass der Hohlraum (9) auf einen Druck unterhalb des Schwellenwerts Pₘₐₓ abgepumpt wird.

## Claims

1. A cryostat arrangement (1'; 1"; 1'''; 1''''), having a vacuum container (2) and an object (4) to be cooled, wherein the object (4) to be cooled is arranged inside the vacuum container (2), wherein the vacuum container (2) has a neck tube (8), which leads to the object (4) to be cooled, wherein a cooling arm (10) of a cold head (11) is at least partially arranged in the neck tube (8), wherein a closed cavity (9), which is sealed off fluid-tight in relation to the object (4) to be cooled, is formed around the cooling arm (10), wherein the cavity (9) is at least partially filled with a cryogenic fluid in normal operation, and wherein a thermal coupling means (15) is provided, suitable for thermal coupling of the cryogenic fluid in the cavity (9) with the object (4) to be cooled,
wherein
the cryostat arrangement (1'; 1"; 1'''; 1'''') comprises a pump device (14), to which the cavity (9) is connected via an activatable valve (13) and using which the cavity (9) can be pumped out in the event of a drop of the cooling function of the cold head (11), and a monitoring unit (17) is provided, which monitors the cooling function of the cold head (11), and is designed to automatically activate the pump device (14) in the event of a drop of the cooling function of the cold head (11) in such a way that the cavity (9) is pumped out,
**characterized in that**
a pressure sensor (30) is fluidically connected to the cavity (9), the output signal of which can be fed into the monitoring unit (17), and the monitoring unit (17) is designed to activate the pump device (14) to pump out the cavity (9) as soon as the output signal of the pressure sensor (30) exceeds a predefined first threshold value Pₘₐₓ of 10kPa (100mbar) ≤ Pₘₐₓ ≤ 50kPa (500mbar).

2. The cryostat arrangement according to claim 1, **characterized in that** the pressure sensor (30) is arranged in the cavity (9).

3. The cryostat arrangement as claimed in claim 2, **characterized in that** the pump device (14), after its activation because of exceeding the first threshold value Pₘₐₓ, only pumps out the cavity (9) until the output signal of the pressure sensor (30) falls below a predefined second threshold value Pₘᵢₙ, wherein 7.5kPa (75mbar) ≤ Pₘᵢₙ ≤ 30kPa (300mbar).

4. The cryostat arrangement as claimed in any one of the preceding claims,
**characterized in that** the activatable valve (13) is embodied as a regulating valve.

5. The cryostat arrangement as claimed in claim 4, **characterized in that** the pump device (14) is designed so that it is operated at constant speed and/or pumping capacity.

6. The cryostat arrangement as claimed in any one of claims 1 to 4,
**characterized in that** the pump device (14) is designed so that it can be operated with variable, settable speed and/or pumping capacity.

7. The cryostat arrangement as claimed in claim 6, **characterized in that** the activatable valve (13) is embodied as an ON/OFF valve.

8. The cryostat arrangement as claimed in any one of claims 1 to 7,
**characterized in that** the pump device (14) comprises an electrically operated suction pump buffered by means of an autonomous power source.

9. The cryostat arrangement as claimed in any one of claims 1 to 7,
**characterized in that** the pump device (14) comprises a cryopump (40), which is integrated in the cryostat arrangement.

10. The cryostat arrangement as claimed in claim 9, **characterized in that** the pumping cold surfaces of the cryopump (40) are thermally coupled to the object (4) to be cooled, wherein a connecting line from the cavity (9) to the pumping cold surfaces extends completely inside the vacuum container (2).

11. The cryostat arrangement as claimed in any one of the preceding claims,
**characterized in that** a supply line (33) is fluidically connected to the cavity (9), using which the cavity (9) is refillable with cryogenic fluid after the cooling function of the cavity (9) is put back into operation.

12. A method for operating a cryostat arrangement (1'; 1"; 1'''; 1'''') as claimed in any one of the preceding claims, having a vacuum container (2) and an object (4) to be cooled, wherein the object (4) to be cooled is arranged inside the vacuum container (2), wherein the vacuum container (2) has a neck tube (8), which leads to the object (4) to be cooled, wherein a cooling arm (10) of a cold head (11) is at least partially arranged in the neck tube (8), wherein a closed cavity (9), which is sealed off fluid-tight in relation to the object (4) to be cooled, is formed around the cooling arm (10), wherein the cavity (9) is at least partially filled with a cryogenic fluid in normal operation, and wherein a thermal coupling means (15) is provided, suitable for thermal coupling of the cryogenic fluid in the cavity (9) with the object (4) to be cooled,
**characterized in that**
the cavity (9) is pumped out via a pump device (14) in such a way that the pressure in the cavity (9) does not exceed a predefined first threshold value Pmaxof 10kPa (100mbar) ≤ Pₘₐₓ ≤ 50kPa (500mbar).

13. The method as claimed in claim 12, **characterized in that** the cavity (9) is pumped out via a pump device (14) in such a way that the pressure in the cavity (9) does not fall below a predefined second threshold value Pₘᵢₙ < Pₘₐₓ.

14. The method as claimed in either of claims 12 or 13, **characterized in that** helium is used as a cryogenic fluid, and the pump device (14) is operated in such a way that in normal operation, the pressure in the cavity (9) is between 15kPa (150 mbar) and 35kPa (350 mbar).

15. The method as claimed in anyone of claims 12 to 14 for operating the cryostat arrangement (1'; 1"; 1'''; 1'''') having the activatable pump device (14), to which the cavity (9) is connected via the activatable valve (13), and having the monitoring unit (17), which monitors the cooling function of the cold head (11) and/or the pressure in the cavity (9), **characterized in that** the monitoring unit (17) activates the pump device (14) if the cooling function of the cold head (11) drops and/or if the pressure in the cavity (9) exceeds the predefined first threshold value Pₘₐₓ in such a way that the cavity (9) is pumped out to a pressure below the threshold value Pₘₐₓ.

## Revendications

1. Arrangement de cryostat (1' ; 1"; 1'''; 1''''), comprenant un réservoir sous vide (2) et un objet (4) à refroidir, l'objet (4) à refroidir étant disposé à l'intérieur du réservoir sous vide (2), le réservoir sous vide (2) comportant un tube formant col (8) qui mène à l'objet (4) à refroidir, un bras de refroidissement (10) d'une tête froide (11) étant disposé au moins partiellement dans le tube formant col (8), un espace creux (9) fermé étant formé autour du bras de refroidissement (10), lequel est rendu étanche aux fluides par rapport à l'objet (4) à refroidir, l'espace creux (9) étant, en fonctionnement normal, au moins partiellement rempli d'un fluide cryogénique, et un moyen de couplage thermique (15) étant présent, adapté pour le couplage thermique du fluide cryogénique dans l'espace creux (9) avec l'objet (4) à refroidir, l'arrangement de cryostat (1' ; 1"; 1'''; 1'''') comportant un système de pompage (14) auquel est raccordé l'espace creux (9) par le biais d'une vanne (13) commandable et avec lequel l'espace creux (9) peut être vidé par pompage dans le cas d'une panne de la fonction de refroidissement de la tête froide (11),
et en ce qu'un dispositif de surveillance (17) est présent, lequel surveille la fonction de refroidissement de la tête froide (11) et lequel est conçu pour activer automatiquement le système de pompage (14) en cas de panne de la fonction de refroidissement de la tête froide (11) de telle sorte que l'espace creux (9) est vidé par pompage,
**caractérisé en ce**
**qu'**un capteur de pression (30) est en liaison fluidique avec l'espace creux (9), dont le signal de sortie peut être injecté dans le dispositif de surveillance (17), et **en ce que** le dispositif de surveillance (17) est réalisé de telle sorte qu'il active le système de pompage (14) en vue de vider l'espace creux (9) par pompage dès que le signal de sortie du capteur de pression (30) dépasse une première valeur de seuil Pₘₐₓ prédéfinie de 10 kPa (100 mbar) ≤ Pₘₐₓ ≤ 50 kPa (500 mbar).

2. Arrangement de cryostat selon la revendication 1, **caractérisé en ce que** le capteur de pression (30) est disposé dans l'espace creux (9).

3. Arrangement de cryostat selon la revendication 2, **caractérisé en ce que** le système de pompage (14), après son activation en raison d'un dépassement de la première valeur de seuil Pₘₐₓ ne vide l'espace creux (9) par pompage que jusqu'à ce que le signal de sortie du capteur de pression (30) devienne inférieur à une deuxième valeur de seuil Pₘᵢₙ prédéfinie, avec 7,5 kPa (75 mbar) ≤ Pₘᵢₙ ≤ 30 kPa (300 mbar).

4. Arrangement de cryostat selon l'une des revendications précédentes, **caractérisé en ce que** la vanne (13) commandable est réalisée sous la forme d'une vanne de régulation.

5. Arrangement de cryostat selon la revendication 4, **caractérisé en ce que** le système de pompage (14) est configuré de telle sorte qu'il fonctionne avec une vitesse et/ou une puissance de pompe constante.

6. Arrangement de cryostat selon l'une des revendications 1 à 4, **caractérisé en ce que** le système de pompage (14) est configuré de telle sorte qu'il peut fonctionner avec une vitesse et/ou une puissance de pompe variable réglable.

7. Arrangement de cryostat selon la revendication 6, **caractérisé en ce que** la vanne (13) commandable est réalisée sous la forme d'une vanne tout-ou-rien.

8. Arrangement de cryostat selon l'une des revendications 1 à 7, **caractérisé en ce que** le système de pompage (14) comporte une pompe d'aspiration à fonctionnement électrique, amortie au moyen d'une source de courant autonome.

9. Arrangement de cryostat selon l'une des revendications 1 à 7, **caractérisé en ce que** le système de pompage (14) comporte une cryopompe (40) qui est intégrée dans l'arrangement de cryostat.

10. Arrangement de cryostat selon la revendication 9, **caractérisé en ce que** les surfaces froides de pompage de la cryopompe (40) sont couplées thermiquement à l'objet (4) à refroidir, une conduite de liaison de l'espace creux (9) aux surfaces froides de pompage s'étendant entièrement dans le réservoir sous vide (2).

11. Arrangement de cryostat selon l'une des revendications précédentes, **caractérisé en ce qu'**une conduite d'arrivée (33) est reliée fluidiquement à l'espace creux (9), avec laquelle l'espace creux (9) peut de nouveau être rempli de fluide cryogénique après la remise en service de la fonction de refroidissement l'espace creux (9).

12. Procédé pour faire fonctionner un arrangement de cryostat (1'; 1"; 1'''; 1'''') selon l'une des revendications précédentes, comprenant un réservoir sous vide (2) et un objet (4) à refroidir, l'objet (4) à refroidir étant disposé à l'intérieur du réservoir sous vide (2), le réservoir sous vide (2) comportant un tube formant col (8) qui mène à l'objet (4) à refroidir, un bras de refroidissement (10) d'une tête froide (11) étant disposé au moins partiellement dans le tube formant col (8), un espace creux (9) fermé étant formé autour du bras de refroidissement (10), lequel est rendu étanche aux fluides par rapport à l'objet (4) à refroidir, l'espace creux (9) étant, en fonctionnement normal, au moins partiellement rempli d'un fluide cryogénique, et un moyen de couplage thermique (15) étant présent, adapté pour le couplage thermique du fluide cryogénique dans l'espace creux (9) avec l'objet (4) à refroidir,
**caractérisé en ce**
**que** l'espace creux (9) est vidé par pompage par le biais d'un système de pompage (14) de telle sorte que la pression dans l'espace creux (9) ne dépasse pas une première valeur de seuil Pₘₐₓ prédéfinie de 10 kPa (100 mbar) ≤ Pₘₐₓ ≤ 50 kPa (500 mbar).

13. Procédé selon la revendication 12, **caractérisé en ce que** l'espace creux (9) est vidé par pompage par le biais d'un système de pompage (14) de telle sorte que la pression dans l'espace creux (9) ne devient pas inférieure à une deuxième valeur de seuil prédéfinie Pₘᵢₙ < Pₘₐₓ.

14. Procédé selon l'une des revendications 12 ou 13, **caractérisé en ce que** le fluide cryogénique utilisé est de l'hélium et **en ce que** le système de pompage (14) fonctionne de telle sorte qu'en fonctionnement normal, la pression dans l'espace creux (9) est comprise entre 15 kPa (150 mbar) et 35 kPa (350 mbar).

15. Procédé selon l'une des revendications 12 à 14 pour faire fonctionner l'arrangement de cryostat (1' ; 1" ; 1''' ; 1'''') comprenant le système de pompage (14) commandable, auquel l'espace creux (9) est raccordé par le biais de la vanne (13) commandable, et comprenant aussi le dispositif de surveillance (17) qui surveille la fonction de refroidissement de la tête froide (11) et/ou la pression dans l'espace creux (9), **caractérisé en ce que** le dispositif de surveillance (17), en cas de panne de la fonction de refroidissement de la tête froide (11) et/ou en cas de dépassement de la pression dans l'espace creux (9) au-dessus de la première valeur de seuil Pₘₐₓ prédéfinie, active le système de pompage (14) de telle sorte que l'espace creux (9) est vidé par pompage à une pression inférieure à la valeur de seuil Pₘₐₓ.
